# EUROPEAN PATENT APPLICATION

(11) **EP 4 492 078 A1**
(43) Date of publication of application: **15.01.2025**
(21) Application number: 23184413.5
(22) Date of filing: 10.07.2023
(51) Int. Cl.: G01R 33/3873, G01R 33/44

(54) **MAGNETIC RESONANCE EXAMINATION APPARATUS WITH A SHIM SYSTEM COMPRISING MULTIPLE SETS OF SHIM ELEMENTS**

(71) Applicant: Koninklijke Philips N.V., 5656 AG Eindhoven (NL)
(72) Inventor: FORTHMANN, Peter, Eindhoven (NL); AMTHOR, Thomas Erik, Eindhoven (NL)
(74) Representative: Philips Intellectual Property & Standards

(57) **Abstract**

According to the invention, a magnetic resonance examination apparatus (2), with a magnetic field-generating unit (14) for generating a main magnetic field and a shim system (1) for enhancing the homogenization of the main magnetic field, the shim system (1) comprising a shim opening (12) and at least a first set of shim elements (4) and a second set of shim elements (6) which are individually insertable into the shim opening (12) by a shim set controller (7), wherein the first set of shim elements (4) is adapted for shimming a first main magnetic field with a first magnetic flux density generated by the magnetic field-generating unit (14) to uniformity when the first set of shim elements (4) is inserted into the shim opening (12), the second set of shim elements (6) is adapted for shimming a second main magnetic field with a second magnetic flux density generated by the magnetic field-generating unit (14) to uniformity when the second set of shim elements (6) is inserted into the shim opening (12), and the second magnetic flux density is different from the first magnetic flux density. In this way shim elements for reducing the effects of magnetic field inhomogeneities in magnetic resonance examination apparatuses are provided.

## Description

### FIELD OF THE INVENTION

The invention relates to the field of magnetic resonance examination. In particular, the present invention relates to the field of shimming a magnetic resonance examination apparatus employing shim elements.

### BACKGROUND OF THE INVENTION

High-temperature superconductors enable magnets to be ramped very quickly, which in turn enables magnetic resonance examination apparatuses to be constructed employing a switchable magnetic flux density of the main magnetic field. This allows intra-examination magnetic flux density switching of the main magnetic field to a further magnetic flux density of a further main magnetic field of the magnetic resonance examination apparatus. Herein, magnetic resonance examination apparatuses include magnetic resonance imaging apparatuses primarily intended for diagnostic imaging on a patient and nuclear magnetic resonance apparatuses. For example, imaging is carried out with a magnetic resonance imaging apparatus at a main magnetic field of 1.5 T. Subsequent switching of the high-temperature superconductor as a magnetic field-generating unit would cause a change in magnetic flux density to a further main magnetic field of 0.6 T and enable acquisition of further magnetic resonance images at this lower magnetic flux density. However, the shimming is still set so that the main magnetic field at, for example, 1.5 T is homogeneous. The further main magnetic field shows inhomogeneities due to the change in magnetic flux density, because the shimming was not performed for the further magnetic flux density different from the first magnetic flux density.

Therefore, shimming, in general, is the process that provides the maximum possible homogenization of the main magnetic field. Shimming in magnetic resonance imaging (MRI) is the process of optimizing the uniformity of the static magnetic field (B0) within the imaging volume. Magnetic field inhomogeneity can lead to image distortions and artifacts, which can significantly impair the quality and accuracy of MR images. The process of shimming involves adjusting the currents in shim coils which are part of the MRI scanner. These shim coils create additional, small magnetic fields that add or subtract from the main magnetic field to compensate for variations and create a more uniform field. The term "shim" originates from a practice in physical mechanics where thin pieces of metal (shims) are inserted to align or adjust parts for a better fit. In the context of MRI, "shimming" is essentially an alignment or adjustment of the magnetic field to optimize image quality.

A distinction is made between active and passive shimming. Passive shimming is carried out by placing and positioning ferromagnetic materials on the inside of the magnet forming the main magnetic field and serves to minimize the inhomogeneities caused by the design of the magnetic resonance imaging apparatus. These ferromagnetic materials are also called shim irons. They become magnetized and produce their own magnetic field. Active shimming can be carried out using shim coils provided for this purpose. Active shimming homogenizes the inhomogeneities in the main magnetic field caused by the patient load. The additional magnetic fields from the shim coils or shim irons, respectively, add to the overall magnetic field of the magnetic field-generating unit in such a way as to increase the homogeneity of the total field.

Typically, the magnetic resonance imaging apparatus comprises shim openings along the longitudinal axis of the magnetic field-generating unit into which shim rails are permanently inserted and the number of such shim openings is 20 to 40. Shim elements comprising a number of shim irons are placed into these pockets during commissioning of the magnetic resonance imaging apparatus. The number of shim irons depends on the shimming requirements and is subject to the calculation of the required shimming in the course of the shimming procedure.

The inhomogeneities caused by the change in the magnetic flux density of the main magnetic field cause image artifacts in the magnetic resonance imaging apparatus that cannot be sufficiently reduced by active shimming.

Accurate homogenization of the main magnetic field is critical in magnetic resonance imaging to reduce inhomogeneity artifacts in the magnetic resonance image. However, with existing rampable magnetic resonance imaging scanners and the ability to change the main magnetic field, homogenization of the main magnetic field is not sufficient.

### SUMMARY OF THE INVENTION

It is an object of the invention to enhance the process of shimming for reducing effects of magnetic field inhomogeneities in magnetic resonance examination apparatuses.

According to the invention, this object is addressed by the subject matter of the independent claims. Preferred embodiments of the invention are described in the dependent claims.

Therefore, according to the invention, a magnetic resonance examination apparatus, with a magnetic field-generating unit for generating a main magnetic field and a shim system for enhancing the homogenization of the main magnetic field, the shim system comprising a shim opening and at least a first set of shim elements and a second set of shim elements which are individually insertable into the shim opening by a shim set controller, wherein the first set of shim elements is adapted for shimming a first main magnetic field with a first magnetic flux density generated by the magnetic field-generating unit to uniformity when the first set of shim elements is inserted into the shim opening, the second set of shim elements is adapted for shimming a second main magnetic field with a second magnetic flux density generated by the magnetic field-generating unit to uniformity when the second set of shim elements is inserted into the shim opening, and the second magnetic flux density is different from the first magnetic flux density.

The term "shimming a main magnetic field to uniformity" means that such a shimming is applied with which image distortions due to field inhomogeneities are reduced. However, while such shimming may help to greatly reduce field inhomogeneities, such shimming will never be able to achieve a completely uniform main magnetic field. The shimming is adapted for achieving at least better uniformity than without the respective set of shim elements.

To achieve homogeneity at the different magnetic flux densities, the two sets of shim elements differ from each other. This means that only one of the two sets of shim elements is arranged individually in the shim opening. If the magnetic flux density of the magnetic field-generating unit changes, the set of shim elements is also changed with the shim set controller. The shim set controller can be a manual control element that waits for input from an end user to cause the set of shim elements in the shim opening to change. Similarly, the shim set controller may also be a lever or button that must be actuated in order for the first set of shim elements, for example, to be removable from the shim opening and for the second set of shim elements to be insertable into the shim opening. In addition, the shim set controller can be designed to detect the change in the magnetic flux density of the magnetic field-generating unit and cause a change to the corresponding set of shim elements.

Preferably, for each change in magnetic flux density, the magnetic resonance examination apparatus has a respective set of shim elements with which the magnetic field corresponding to the change in magnetic flux density can be shimmed to uniformity. This enables passive shimming for the magnetic resonance examination apparatus outside the commissioning phase.

In general, the sets of shim elements can be arranged in different ways. According to a preferred embodiment of the invention, however, the magnetic resonance examination apparatus further comprises a shim tray which comprises multitude shim pockets, wherein the first set of shim elements comprises a multitude of first-set shim elements, the second set of shim elements comprises a multitude of second-set shim elements, each of the first-set shim element and the second-set shim element are adapted for being arranged individually in one respective shim pocket of the shim tray and the shim tray is insertable into the shim opening of the magnetic field-generating unit.

This means that the first-set shim elements and the second-set shim elements can already be configured in such a way that only the shim trays containing the sets of shim elements need to be inserted into the shim opening. However, the individual shim elements can still be removed individually from the shim pockets and exchanged, so that further sets of shim elements are also possible by combining the individual first-set shim elements and second-set shim elements.

In principle, it is possible to insert the sets of shim elements into the shim opening of the magnetic field-generating unit in different ways. Furthermore, it is possible to design the shim opening in different ways. According to a preferred embodiment of the invention, however, the magnetic resonance examination apparatus comprises a rail provided in the shim opening, the rail extending within the shim opening from a first end of the magnetic field-generating unit along a longitudinal axis to a second end of the magnetic field-generating unit, wherein the first set of shim elements and the second set of shim elements are adapted for being arranged in the shim tray along the longitudinal axis, the shim tray inserted in the shim opening extends from the magnetic field-generating unit such that either the first set of shim elements or the second set of shim elements is arranged in a part of the shim tray inserted in the shim opening, the first set of shim elements comprises first-set shim elements arranged in the shim pockets adjacent to each other along the longitudinal axis and as the second set of shim elements comprises second-set shim elements arranged in the shim pockets adjacent to each other along the longitudinal axis, and the shim tray is adapted for sliding along the rail in the shim opening such that the shim tray can be switched between a first position in which the first set of shim elements is arranged in the shim opening and a second position in which the second set of shim elements is arranged in the shim opening.

The longitudinal axis is parallel to the longitudinal axis of the aperture in the magnetic resonance examination apparatus. It must be considered that by arranging the sets of shim elements adjacent to each other, the respective sets of shim elements influence each other with respect to the main magnetic field. The entire arrangement of the sets of shim elements is therefore optimized for homogeneity for both configurations, i.e. the first set of shim elements is inserted in the shim opening in the first position and the second set of shim elements extends from the shim opening and vice versa. In order to reduce the influence on the main magnetic field in the opening of the magnetic resonance examination apparatus, the bore, it can be provided that the first set of shim elements is spaced from the second set of shim elements by the distance of a shim pocket or further.

With the rail formed in the shim opening, it is possible to move the shim tray comprising the two sets of shim elements between the first and second positions.

It is possible to form the rail in different ways. However, according to a preferred embodiment of the invention, the magnetic resonance examination apparatus further comprises a latch provided on the shim tray, the latch being lockable and unlockable so that the shim tray can be held stationary in the shim opening with the latch locked, and the shim tray is movable along the rail with the latch unlocked.

Particularly regarding the changing magnetic fields of gradient coils in the magnetic resonance examination apparatus during the acquisition of images, the latch ensures that the set of shim elements remains stationary in the shim opening, thus ensuring the homogeneity of the main magnetic field. Likewise, the latch may be provided on the rail to inhibit movement of the shim tray.

According to a particularly preferred embodiment of the invention the magnetic resonance examination apparatus comprises additionally an actuating mechanism arranged on the magnetic field-generating unit, wherein the shim tray is movable along the rail with the actuating mechanism.
The actuating mechanism can be operated with the shim set controller, as can the latch. This makes it possible to move the shim tray to a position where the respective main magnetic field is shimmed to homogeneity with the corresponding set of shim elements.

In principle, the shim tray can be designed in different ways. However, according to a preferred embodiment of the invention, the shim tray is formed with joints interconnecting the shim pockets such that the shim pockets are movable around an axis perpendicular to the longitudinal axis, and the rail extends beyond the first end and the second end of the magnetic field-generating unit and curves around the magnetic field-generating unit such that the rail forms a closed path and the shim tray is movable along this path.

Thus, the rail generally follows the magnetic field lines of the main magnetic field. The first set of shim elements may be spaced from the second set of shim elements by one or more further joints. Similarly, the first set of shim elements need not be connected to the second set of shim elements. Each of the sets of shim elements may be extendable from the shim opening at the respective first end or the second end. In space-sensitive areas, the sets of shim elements can thus be stored in a space-saving manner. In addition, the set of shim elements not inserted in the shim opening has less influence on the main magnetic field in the bore if it is stored on the opposite side of the rail to the shim opening.

In general, the magnetic field-generating unit can be designed in different ways. According to a preferred embodiment of the invention, however, the magnetic resonance examination apparatus moreover comprises at least one stiffener ring on the magnetic field-generating unit such that the mechanical stability of the shim tray is increased. With the stiffening ring, the load of the weight of the shim tray is absorbed. The shim opening in the magnetic field-generating unit is relieved as well as the rail formed in the shim opening.

It is possible to configure the magnetic resonance examination apparatus in different ways. According to a preferred embodiment of the invention, however, the magnetic resonance examination apparatus moreover comprises a bore, the magnetic field-generating unit surrounding the bore, wherein the field-generating unit comprises a multitude of shim openings which run parallel to the longitudinal axis of the bore and a computation unit with which the main magnetic field is switchable between a first main magnetic field comprising a first magnetic flux density and a second main magnetic field comprising a second magnetic flux density.

In general, the shim set controller can be operated by a user of the magnetic resonance examination apparatus. However, according to a preferred embodiment of the invention the shim set controller is adapted for automatically inserting the correct set of shim elements for the respective main magnetic field. For this purpose, it can be provided that the computation unit is connected to the shim set controller for signal transmission, so that the computation unit can cause the shim set controller to change the set of shim elements when the main magnetic field changes. Wherein the correct set of shim elements is the set of shim elements, that yields the homogenization with the corresponding magnetic flux density.

In principle, each shim opening can be provided with first set or second set shim elements. According to a preferred embodiment of the invention, however, a number of the multitude shim openings are provided with fixed shim elements which do not have to be removed when changing between the first and the second main magnetic field.

Regarding the influence on the main magnetic field of the magnetic resonance examination apparatus, there is an overlap between a configuration in which the first set of shim elements is placed in the shim openings and a configuration in which the second set of shim elements is placed in the shim openings. Fixed shim elements are shim elements that can remain in the shim openings during changes in the main magnetic field. This means that only a part of the shim openings must be equipped with the correct set of shim elements. Similarly, it may be that the first main magnetic field is already homogeneously shimmed with the fixed shim elements at a lower magnetic flux density and that only for the second main magnetic field the second set of shim elements is inserted into the shim openings not occupied with fixed sets of shim elements.

The invention further concerns a method of shimming a magnetic resonance examination apparatus according to the above, comprising the following method steps: inserting the first set of shim elements or the second set of shim elements into the shim openings, respectively, and ramping the main magnetic flux density to the first magnetic flux density of the first main magnetic field or the second magnetic flux density of the second main magnetic field, respectively.
According to a preferred embodiment of the invention, the first magnetic flux density is lower than the second magnetic flux density, with the additional method step: ramping the main magnetic flux density down to the first magnetic flux density of the first main magnetic field. In order to reduce magnetic forces on the sets of shim elements during actuation, the main magnetic field is ramped down prior to actuation and up again after it. In this case, actuation means changing the set of shim elements.

Further, according to the invention a computer program for magnetic resonance examination apparatus, comprising instructions which, when the program is executed by a computer, cause the computer to perform a method according to the above is provided.

The invention further relates to a shimming set for enhancing the homogenization of the main magnetic field of a magnetic resonance examination apparatus, with at least a first set of shim elements and a second set of shim elements which are individually insertable into a shim opening of the magnetic resonance examination apparatus, respectively, wherein the first set of shim elements and the second set of shim elements differ in at least one of the shim elements.

The shim elements have a certain order. In this order, at least one shim element of the first set, e.g. the third shim element, is different from the respective (e.g. third) shim element of the second set. A shim element may be comprised by multiple identical shim irons. In this situation, the number of shim irons for the respective shim element of the first set or the second set, respectively, would be different.

It is possible to arrange the sets of shim elements in different ways. However, according to a preferred embodiment of the invention, the first set of shim elements and the second set of shim elements are connected to each other.

### BRIEF DESCRIPTION OF THE DRAWINGS

These and other aspects of the invention will be apparent from and elucidated with reference to the embodiments described hereinafter. Such an embodiment does not necessarily represent the full scope of the invention, however, and reference is made therefore to the claims and herein for interpreting the scope of the invention.

In the drawings:
Fig. 1 schematically depicts sets of shim elements according to a preferred embodiment of the invention,
Fig. 2 schematically depicts sets of shim elements according to another preferred embodiment of the invention,
Fig. 3 schematically depicts a magnetic resonance examination apparatus according to a preferred embodiment of the invention; and
Fig. 4 schematically depicts a scheme of a method according to a preferred embodiment of the invention.

### DETAILED DESCRIPTION OF EMBODIMENTS

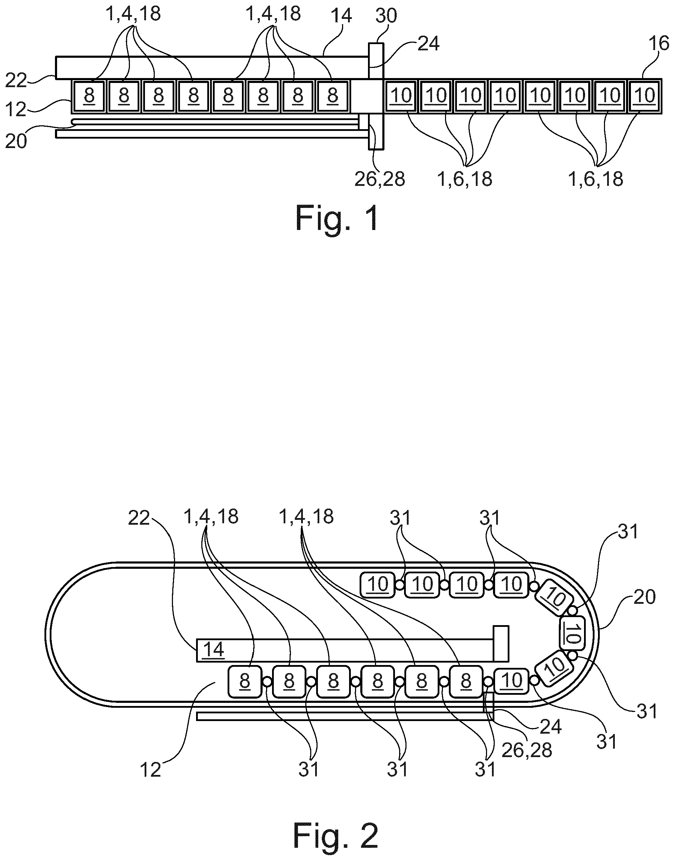

Fig. 1 schematically depicts sets of shim elements (1) according to a preferred embodiment of the invention. A first set of shim elements 4 is arranged adjacent to a second set of shim elements 6 in a shim tray 16. The shim tray 16 has shim pockets 18, with one first-set shim element 8 being arranged in each of the shim pockets 18 of the first set of shim elements 4. Similarly, in the shim pockets 18 of the second set of shim elements 6, a second-set shim element 10 is arranged in a shim pocket 18 in each case. The first-set shim elements 8 and the second-set shim elements 10 are arranged in a specific order in the shim pockets 18 of the shim tray 16 in order to be able to shim a respective first main magnetic field and a respective second main magnetic field to uniformity. The individual shim element 8, 10 is composed of a plurality of individual identical shim irons. The main magnetic field can then be shimmed via the number of shim irons in a single shim element 8, 10 in a shim pocket 18 of the respective set of shim elements 1 for all shim elements 8,10 of the set of shim elements 1. The first set of shim elements 4 is spaced from the second set of shim elements 6 via a shim pocket 18. The shim tray 16 is arranged in the shim opening 12 of a magnetic field-generating unit 14 of a magnetic resonance examination apparatus 2 in a first position in which the first set of shim elements 4 is in the shim opening 12.

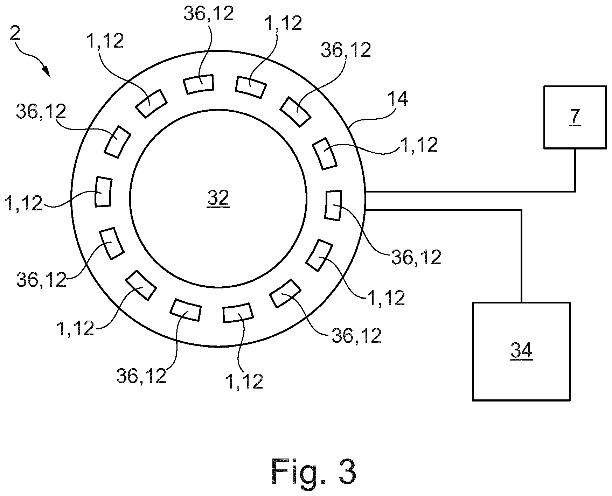

A stiffening ring 30 disposed at a second end 24 protects the shim opening 12 from the load of the shim tray 16. The shim tray 16 is movable mounted on a rail 20 disposed in the shim opening 12. The rail 20 extends from a first end 22 of the shim opening 12 to the second end 24 of the shim opening 12 and is provided with a latch 26 for holding the shim tray in a respective position. In addition, an actuation mechanism 28 is provided at the latch 26 for moving the shim tray 16 along the rail 20 within the shim opening 12. The actuation mechanism 28, like the latch 26, is connected to a shim set controller 7 shown in Fig. 3.

In Fig. 3, the magnetic field-generating unit 14 of the magnetic resonance examination apparatus 2 is shown in a front view. The shim openings 12 are arranged radially in the magnetic field-generating unit 14 and extend parallel along a bore 32 of the magnetic field-generating unit 14. Every second shim opening 12 is provided with a fixed shim element 36. Each shim opening 12 that is not provided with a fixed shim element 36 has a set of shim elements 1.

The magnetic field-generating unit 14 comprises a rampable superconducting magnet. With a computation unit 34 connected to the magnetic field-generating unit 14, the main magnetic field is switchable between a first main magnetic field comprising a first magnetic flux density and a second main magnetic field comprising a second magnetic flux density. Furthermore, the computation unit 34 is connected to the shim set controller 7 via the magnetic field-generating unit 14. When the magnetic flux density is changed from the first main magnetic field to the second main magnetic field between two imaging sequences acquiring images with the magnetic resonance examination device 2, the shim set controller 7 actuates the actuation mechanisms 28 and the shim trays 16 change from the first position to a second position in which the second set shim elements 6 are inserted into the shim openings 12 so that the second main magnetic field is shimmed to uniformity with the second set shim elements 6.

Fig. 2 schematically depicts sets of shim elements 1 according to another preferred embodiment of the invention, wherein the rail 20 extends beyond the first end 22 and the second end 24 and curves around the magnetic field-generating unit 14. The rail 20 forms a closed loop on which the shim tray 16 is movable. For this purpose, the individual shim pockets 18 receiving the first-set shim elements 8 and the second-set shim elements 10 are connected to each other via joints 31, which are movable in a direction perpendicular to the longitudinal axis, so that the shim tray 16 can follow the course of the rail 20. With the actuation mechanism 28 and the latch 26, the first set of shim elements 4 is inserted in the shim opening 12 and the second set of shim elements 6 is inserted on the side of the rail 20 opposite the shim opening 12.

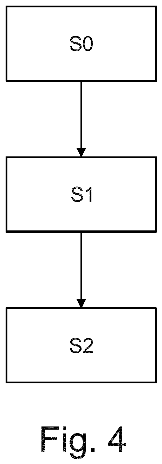

Fig. 4 schematically depicts a scheme of a method of shimming a magnetic resonance examination apparatus 2. Wherein in a first step the magnetic flux density is ramped down to the first magnetic flux density of the first main magnetic field. The second sets of shim elements 4 are then inserted into the shim openings 12 in a second step. Third, the magnetic flux density is ramped to the second magnetic flux density of the second main magnetic field.

While the invention has been illustrated and described in detail in the drawings and foregoing description, such illustration and description are to be considered illustrative or exemplary and not restrictive; the invention is not limited to the disclosed embodiments. Other variations to the disclosed embodiments can be understood and effected by those skilled in the art in practicing the claimed invention, from a study of the drawings, the disclosure, and the appended claims. In the claims, the word "comprising" does not exclude other elements or steps, and the indefinite article "a" or "an" does not exclude a plurality. The mere fact that certain measures are recited in mutually different dependent claims does not indicate that a combination of these measures cannot be used to advantage. Any reference signs in the claims should not be construed as limiting the scope. Further, for the sake of clearness, not all elements in the drawings may have been supplied with reference signs.

### REFERENCE SYMBOL LIST

| | |
|---|---|
| Sets of shim elements | 1 |
| Magnetic resonance examination apparatus | 2 |
| First set of shim elements | 4 |
| second set of shim elements | 6 |
| shim set controller | 7 |
| first-set shim element | 8 |
| second-set shim element | 10 |
| shim opening | 12 |
| magnetic field-generating unit | 14 |
| shim tray | 16 |
| shim pocket | 18 |
| rail | 20 |
| first end | 22 |
| second end | 24 |
| latch | 26 |
| actuating mechanism | 28 |
| stiffener ring | 30 |
| joint | 31 |
| bore | 32 |
| computation unit | 34 |
| fixed shim elements | 36 |

## Claims

1. Magnetic resonance examination apparatus (2), with a magnetic field-generating unit (14) for generating a main magnetic field and a shim system (1) for enhancing the homogenization of the main magnetic field, the shim system (1) comprising a shim opening (12) and at least a first set of shim elements (4) and a second set of shim elements (6) which are individually insertable into the shim opening (12) by a shim set controller (7), wherein
the first set of shim elements (4) is adapted for shimming a first main magnetic field with a first magnetic flux density generated by the magnetic field-generating unit (14) to uniformity when the first set of shim elements (4) is inserted into the shim opening (12),
the second set of shim elements (6) is adapted for shimming a second main magnetic field with a second magnetic flux density generated by the magnetic field-generating unit (14) to uniformity when the second set of shim elements (6) is inserted into the shim opening (12), and
the second magnetic flux density is different from the first magnetic flux density.

2. Magnetic resonance examination apparatus (2) according to claim 1, with a shim tray (16) which comprises multitude shim pockets (18), wherein
the first set of shim elements (4) comprises a multitude of first-set shim elements (8),
the second set of shim elements (6) comprises a multitude of second-set shim elements (10),
each of the first-set shim element (8) and the second-set shim element (10) are adapted for being arranged individually in one respective shim pocket (18) of the shim tray (16) and
the shim tray (16) is insertable into the shim opening (12) of the magnetic field-generating unit (14).

3. Magnetic resonance examination apparatus (2) according to claim 1 or 2, with a rail (20) provided in the shim opening (12), the rail (20) extending within the shim opening (12) from a first end (22) of the magnetic field-generating unit (14) along a longitudinal axis to a second end (24) of the magnetic field-generating unit (14), wherein
the first set of shim elements (4) and the second set of shim elements (6) are adapted for being arranged in the shim tray (16) along the longitudinal axis,
the shim tray (16) inserted in the shim opening (12) extends from the magnetic field-generating unit (14) such that either the first set of shim elements (4) or the second set of shim elements (6) is arranged in a part of the shim tray (16) inserted in the shim opening (12),
the first set of shim elements (4) comprises first-set shim elements (8) arranged in the shim pockets (18) adjacent to each other along the longitudinal axis and as the second set of shim elements (6) comprises second-set shim elements (10) arranged in the shim pockets (18) adjacent to each other along the longitudinal axis, and
the shim tray (16) is adapted for sliding along the rail (20) in the shim opening (12) such that the shim tray (16) can be switched between a first position in which the first set of shim elements (4) is arranged in the shim opening (12) and a second position in which the second set of shim elements (6) is arranged in the shim opening (12).

4. Magnetic resonance examination apparatus (2) according to claim 3, with a latch (26) provided on the shim tray (16), the latch (26) being lockable and unlockable so that the shim tray (16) can be held stationary in the shim opening (12) with the latch (26) locked, and the shim tray (16) is movable along the rail (20) with the latch (26) unlocked.

5. Magnetic resonance examination apparatus (2) according to any one of claims 3 or 4, with an actuating mechanism (28) arranged on the magnetic field-generating unit (14), wherein the shim tray (16) is movable along the rail (20) with the actuating mechanism (28).

6. Magnetic resonance examination apparatus (2) according to any one of the claims 3 to 5, wherein the shim tray (16) is formed with joints (31) interconnecting the shim pockets (18) such that the shim pockets (18) are movable around an axis perpendicular to the longitudinal axis, and
the rail (20) extends beyond the first end (22) and the second end (24) of the magnetic field-generating unit (14) and curves around the magnetic field-generating unit (14) such that the rail (20) forms a closed path and the shim tray (16) is movable along this path.

7. Magnetic resonance examination apparatus (2) according to any one of the claims 2 to 6, with at least one stiffener ring (30) on the magnetic field-generating unit (14) such that the mechanical stability of the shim tray (16) is increased.

8. Magnetic resonance examination apparatus (2) according any one of the preceding claims, with a bore (32), the magnetic field-generating unit (14) surrounding the bore (32), wherein the field-generating unit (14) comprises a multitude of shim openings (12) which run parallel to the longitudinal axis of the bore (32) and a computation unit (34) with which the main magnetic field is switchable between a first main magnetic field comprising a first magnetic flux density and a second main magnetic field comprising a second magnetic flux density.

9. Magnetic resonance examination apparatus (2) according any one of the preceding claims, wherein the shim set controller (7) is adapted for automatically inserting the correct set of shim elements (4, 6) for the respective main magnetic field.

10. Magnetic resonance examination apparatus (2) according any one of the preceding claims, wherein a number of the multitude shim openings (12) are provided with fixed shim elements (36) which do not have to be removed when changing between the first and the second main magnetic field.

11. Method of shimming a magnetic resonance examination apparatus (2) according to any one of the preceding claims, comprising the following method steps:
S1) inserting the first set of shim elements (4) or the second set of shim elements (6) into the shim openings (12), respectively, and
S2) ramping the main magnetic flux density to the first magnetic flux density of the first main magnetic field or the second magnetic flux density of the second main magnetic field, respectively.

12. Method according to claim 11, wherein the first magnetic flux density is lower than the second magnetic flux density, with the additional method step:
S0) ramping the main magnetic flux density down to the first magnetic flux density of the first main magnetic field.

13. Computer program for magnetic resonance examination apparatus, comprising instructions which, when the program is executed by a computer, cause the computer to perform a method according to any one of claims 11 or 12.

14. Shimming set for enhancing the homogenization of the main magnetic field of a magnetic resonance examination apparatus (2), with at least a first set of shim elements (4) and a second set of shim elements (6) which are individually insertable into a shim opening (12) of the magnetic resonance examination apparatus (2), respectively, wherein the first set of shim elements (4) and the second set of shim elements (6) differ in at least one of the shim elements (8, 10).

15. Shimming set according to claim 14, wherein the first set of shim elements (4) and the second set of shim elements (6) are connected to each other.
